# EUROPÄISCHE PATENTSCHRIFT

(11) **EP 2 922 373 B1**
(45) Veröffentlichungstag und Bekanntmachung des Hinweises auf die Patenterteilung: **27.04.2022**
(21) Anmeldenummer: 15155626.3
(22) Anmeldetag: 18.02.2015
(51) Int. Cl.: H05K 3/32, H01R 43/02, H05K 5/00, H01R 4/02, H05K 3/20

(54) **VERFAHREN ZUM VERBINDEN ZWEIER ELEKTRISCH LEITENDER BAUTEILE MITTELS EINES LASERSTRAHLS UND BAUTEILEVERBUND**
METHOD FOR CONNECTING TWO ELECTRICALLY CONDUCTIVE COMPONENTS BY MEANS OF A LASER BEAM AND COMBINATION OF COMPONENTS
PROCÉDÉ DE RACCORDEMENT DE DEUX COMPOSANTS CONDUCTEURS D'ÉLECTRICITÉ AU MOYEN D'UN RAYON LASER ET COMPOSITE DE COMPOSANT

(30) Priorität: 18.03.2014 DE 102014205015
(43) Veröffentlichungstag der Anmeldung: 23.09.2015
(73) Patentinhaber: Robert Bosch GmbH, 70442 Stuttgart (DE)
(72) Erfinder: Wohlschlager, Alexander, 70771 Leinfelden-Echterdingen (DE); Weber, Dieter, 89173 Lonsee (DE); Hohenberger, Bernd, 73240 Wendlingen (DE); Hagel, Mark, 72760 Reutlingen (DE)

(56) Entgegenhaltungen:
- DE-A1- 10 036 900
- DE-A1-102005 035 102
- DE-A1-102009 026 460
- US-A1- 2004 022 296

## Beschreibung

### Stand der Technik

Die Erfindung betrifft ein Verfahren zum Verbinden zweier elektrisch leitender Bauteile mittels eines Laserstrahls nach dem unabhängigen, das Verfahren betreffenden Anspruch.

Ferner betrifft die Erfindung einen Bauteileverbund, der nach einem erfindungsgemäßen Verfahren hergestellt ist.

Ein Verfahren aus dem Stand der Technik findet Verwendung bei Steuergeräten in Kraftfahrzeugen, bei denen ein erstes Bauteil in Form eines bereichsweise mit Kunststoff umspritzten Stanzgitters ausgebildet ist. Das erste Bauteil wird mittels eines Laserstrahls im Bereich einer Verbindungszone mit einem zweiten Bauteil elektrisch leitend verbunden, wobei das zweite Bauteil beispielsweise ein Steckerkontakt oder ein Motoranschlusskontakt ist, der insbesondere stiftförmig ausgebildet ist. Um das erste Bauteil mit dem zweiten Bauteil verbinden zu können, weist das erste Bauteil sowohl auf der dem Laserstrahl zugewandten als auch auf der dem Laserstrahl abgewandten Seite jeweils eine Aussparung auf. In der dem Laserstrahl abgewandten Aussparung des ersten Bauteils liegt dieses vorzugsweise bündig bzw. flächig an dem zweiten Bauteil an. Um zu vermeiden, dass infolge einer Streuung bzw. teilweisen Reflektion des Laserstrahls das Material der Umspritzung auf der dem Laserstrahl zugewandten Seite beschädigt wird, ist es darüber hinaus beim Stand der Technik vorgesehen, dass in die dem Laserstrahl zugewandte Aussparung des ersten Bauteils eine im Bereich der Aussparung insbesondere hülsenförmige (Schutz-)Maske eintaucht, die das Material der Umspritzung vor der Laserstrahlung schützt. Nachteilig dabei ist, dass eine derartige Maske ein relativ großes bzw. aufwendiges Bauteil darstellt, das hochgenau in der Aussparung positioniert werden muss. Dadurch ist die Anzahl von möglichen elektrisch leitenden Kontaktstellen, bezogen auf eine bestimmte Flächengröße des ersten Bauteils, beim Stand der Technik beschränkt, und es ist eine relativ aufwendige bzw. mit einem hochgenau arbeitenden Stellantrieb gekoppelte Maske erforderlich.

Aus der DE 2010 039 146 A1 der Anmelderin ist ein nicht gattungsgemäßes Verfahren bekannt, bei dem eine auf einem Schaltungsträger in Form einer Leiterplatte befindliche Leiterbahn mit einer an einem zweiten Schaltungsträger angeordneten Leiterbahn durch einen Laserstrahl verbunden wird. Hierbei ist auf der dem Laserstrahl zugewandten Seite in der Leiterplatte des ersten Schaltungsträgers eine beispielhaft trichterförmige Aussparung ausgebildet, damit der Laserstrahl unmittelbar auf den Bereich der Leiterbahn einwirken kann. Nach dem Ausbilden der Verbindung ist es vorgesehen, dass die Aussparung mit einer Vergussmasse ausgefüllt wird. Ein derartiges Vorgehen ist immer dann möglich, wenn der Schaltungsträger bzw. die Leiterplatte eine relativ hohe Schmelztemperatur aufweist, so dass trotz eines in das Material der Leiterplatte einwirkenden reflektierten bzw. gestreuten Laserstrahls, insbesondere in Verbindung mit einer relativ geringen Einwirkdauer des Laserstrahls, eine Beschädigung des Schaltungsträgers vermieden wird. Darüber hinaus lässt sich eine ggf. auftretende Beschädigung der Leiterplatte durch die Vergussmasse ausgleichen bzw. reparieren.

Aus der DE 103 06 697 A1 der Anmelderin ist darüber hinaus ein nicht gattungsgemäßes Verfahren zum Verbinden zweier aus Kunststoff bestehender Bauteile mittels eines Laserstrahls bekannt, bei dem das dem Laserstrahl zugewandte erste Bauteil aus einem für den Laserstrahl transparenten Material besteht. Durch Aufschmelzen des in Anlagekontakt mit dem ersten Bauteil befindlichen zweiten Bauteils wird eine kraft- bzw. formschlüssige Verbindung zwischen den beiden Kunststoffteilen ausgebildet.

Aus der DE 195 04 967 A1 ist ein weiteres, ebenfalls nicht gattungsgemäßes Verfahren bekannt, bei dem ein flexibles Substrat mit einer Trägerschicht auf der dem zweiten Bauteil zugewandten Seite mit Kontaktelementen versehen ist. Ein Laserstrahl wird insbesondere mittels einer Lichtleitfaser in das Substrat im Bereich der Kontaktelemente eingeleitet, wobei das Substrat aus einem für die Laserstrahlung durchlässigen bzw. transparenten Material besteht, so dass zumindest im Wesentlichen keine thermische (Über-) Beanspruchung des Substrats außerhalb der Kontaktelemente stattfindet.

Zuletzt ist aus der DE 10 2010 030 070 A1 der Anmelderin ein nicht gattungsgemäßes Verfahren bekannt, bei dem das erste Bauteil auf der dem Laserstrahl zugewandten Seite mit einem Versteifungselement verbunden ist, das für die Laserstrahlung durchlässig ist. Das Versteifungselement dient der eindeutigen Positionierung bzw. Anlage des als flexible Flachleitung ausgebildeten ersten Bauteils in der Verbindungszone zu dem zweiten Bauteil. Zudem sind aus den Offenlegungsschriften DE 10036900 A1 und DE 102005035102 A1 Schweißverfahren bekannt.

### Offenbarung der Erfindung

Ausgehend von dem dargestellten Stand der Technik liegt der Erfindung die Aufgabe zugrunde, ein Verfahren zum Verbinden zweier elektrisch leitender Bauteile mittels eines Laserstrahls derart weiterzubilden, dass auf die Verwendung der beim Stand der Technik bekannten Maskeneinrichtung, die zum Schutz der Umspritzung in die dem Laserstrahl zugewandte Aussparung des ersten Bauteils eintaucht und danach wieder entfernt wird, verzichten zu können.

Diese Aufgabe wird erfindungsgemäß bei dem Verfahren mit den Merkmalen des unabhängigen Anspruchs gelöst.

Bei dem erfindungsgemäßen Verfahren wird vorgeschlagen, dass das erste Bauteil im Bereich der Verbindungszone auf der dem Laserstrahl zugewandten Seite erhöht ausgebildet ist, so dass das erste Bauteil zumindest bis in Höhe des Kunststoffes der Umspritzung auf der dem Laserstrahl zugewandten Seite reicht und vorzugsweise die Umspritzung in diesem Bereich in der Höhe überragt. Mit anderen Worten gesagt bedeutet dies, dass durch eine spezielle geometrische Ausgestaltung des ersten Bauteils im Bereich der Kontaktzone ein von dem ersten Bauteil reflektierter bzw. gestreuter Laserstrahl nicht auf die Umspritzung des ersten Bauteils auf der dem Laserstrahl zugewandten Seite trifft und somit die Umspritzung auch nicht thermisch beanspruchen kann.

In vorzugsweiser Ausgestaltung des erfindungsgemäßen Verfahrens ist es vorgesehen, dass das erste Bauteil im Bereich der Aussparung zur Ausbildung der Erhöhung zumindest bereichsweise verformt wird.

Die Erfindung umfasst auch einen Bauteileverbund, der nach dem erfindungsgemäßen Verfahren hergestellt ist, wobei das erste Bauteil ein aus Kupfer bestehendes Stanzgitter ist.

In weiterer bevorzugter Ausgestaltung des Bauteileverbunds kann es vorgesehen sein, dass das zweite Bauteil zumindest im Bereich der Verbindungszone stiftförmig ausgebildet ist.

### Weiterhin ist es bevorzugt vorgesehen, wenn der Bauteileverbund Bestandteil eines Steuergeräts in einem Kraftfahrzeug ist.

Vorteilhafte Weiterbildungen der Erfindung ergeben sich darüber hinaus durch eine Kombination von in den Ansprüchen, der Beschreibung oder den Figuren offenbarten Merkmalen. Insbesondere sollen dabei verfahrensmäßig formulierte Merkmale als vorrichtungstechnisch offenbart gelten und vorrichtungstechnisch offenbarte Merkmale als verfahrenstechnisch offenbart.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1 und Fig. 2: zwei Bauteileverbunde, die durch ein Verfahren zum Verbinden zweier elektrisch leitender Bauteile unter Verwendung einer für Laserstrahlung transparenten Umspritzung hergestellt sind, jeweils in vereinfachtem Längsschnitt,
- Fig. 3: den Verbindungsbereich zweier elektrisch leitender Bauteile bei einem nach einem erfindungsgemäßen Verfahren hergestellten Bauteileverbund im Längsschnitt und
- Fig. 4: den Verbindungsbereich zweier elektrisch leitender Bauteile eines Bauteileverbunds, ebenfalls im Längsschnitt.

Gleiche Elemente bzw. Elemente mit gleicher Funktion sind in den Figuren mit den gleichen Bezugsziffern versehen.

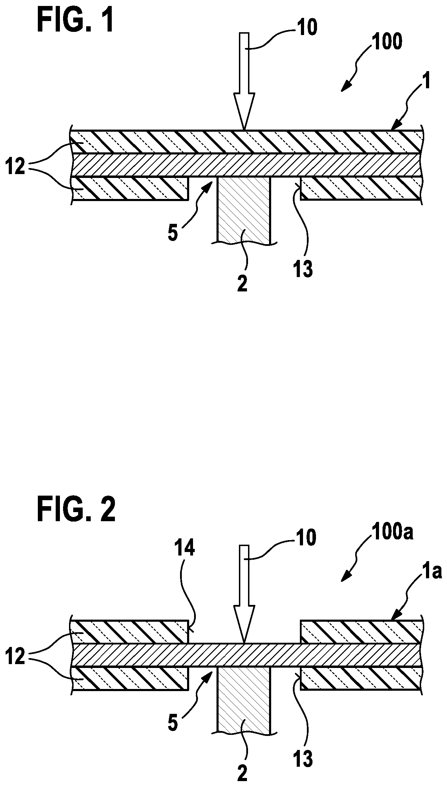

In der Fig. 1 ist ein erster Bauteileverbund 100, bestehend aus einem ersten Bauteil 1 und einem zweiten Bauteil 2 dargestellt, die mittels eines ersten Verfahrens elektrisch leitend miteinander verbunden sind. Bei dem ersten Bauteil 1 handelt es sich insbesondere um einen Teilbereich eines aus einem elektrisch leitendem Material wie Kupfer o.ä. bestehenden Stanzgitters und bei dem zweiten Bauteil 2 um ein in einer Verbindungszone 5 zwischen den beiden Bauteilen 1, 2 stiftförmig ausgebildetes Bauteil 2, das beispielsweise als Kontaktstift, als Motoranschlusspin o.ä. dient. Wesentlich ist, dass die beiden Bauteile 1, 2 aus derartigen Materialien bestehen bzw. derartig angepasste Schmelztemperaturen aufweisen, dass diese mittels eines Laserstrahls 10 miteinander verbunden bzw. verschweißt werden können, wobei die beiden Bauteile 1, 2 hierzu im Bereich der Verbindungszone 5 in unmittelbarem Anlagekontakt, vorzugsweise zusätzlich unter Ausbildung einer Kontaktkraft zwischen den beiden Bauteilen 1, 2, zueinander angeordnet sind.

Der Laserstrahl 10 wird mittels einer nicht dargestellten Laserstrahlquelle, insbesondere mittels eines Halbleiter- oder Festkörperlasers erzeugt.

Das erste Bauteil 1 ist auf der dem Laserstrahl 10 zu- und abgewandten Seite jeweils mit einer Umspritzung 12 aus Kunststoff, wie PBT, PA, ABS, PC, PE PMMA, POM, PP, PS o.ä. versehen, wobei die Umspritzung 12 insbesondere auch im Bereich der Verbindungszone 5 zwischen den beiden Bauteilen 1, 2 auf der dem Laserstrahl 10 zugewandten Seite vorgesehen ist. Wesentlich ist, dass der Laserstrahl 10 eine Wellenlänge aufweist, bei der die verwendeten Kunststoffe eine Transmission der Strahlung von mehr als 1% ermöglichen.

Darüber hinaus weist die Umspritzung 12 des ersten Bauteils 1 auf der dem zweiten Bauteil 2 zugewandten Seite eine erste Aussparung 13 auf, deren Größe der Größe bzw. dem Querschnitt des zweiten Bauteils 2 derart angepasst ist, dass das zweite Bauteil 2, vorzugsweise mit radialem Abstand, in der ersten Ausnehmung 13 angeordnet werden kann bzw. in diese eintaucht und in zumindest punktförmigem, vorzugsweise flächigem Anlagekontakt mit dem (metallischen) ersten Bauteil 1 angeordnet ist.

Eine Bestrahlung des ersten Bauteils 1 mittels des Laserstrahls 10 bewirkt, dass der Laserstrahl 10 zumindest im Wesentlichen die Umspritzung 12 auf der dem zweiten Bauteil 2 abgewandten Seite des ersten Bauteils 1 zumindest nahezu ohne von dem Material der Umspritzung 12 absorbiert zu werden durchdringt und auf das erste Bauteil 1 in dessen metallischen Bereich auftritt und dort für eine lokale Erwärmung bzw. ein lokales Aufschmelzen des ersten Bauteils 1 sorgt. Durch den Anlagekontakt des ersten Bauteils 1 an dem zweiten Bauteil 2 findet eine Wärmeübertragung vom ersten Bauteil 1 auf das zweite Bauteil 2 statt, so dass auch das zweite Bauteil 2 im Bereich der Verbindungszone 5 aufgeschmolzen wird, um nach dem Abschalten des Laserstrahls 10 und einer anschließenden Erstarrung des Materials der beiden Bauteile 1, 2 die beiden Bauteile 1, 2 unter Ausbildung einer nicht dargestellten Laserstrahlschweißnaht fest miteinander zu verbinden.

Der in Fig. 2 dargestellte Bauteileverbund 100a unterscheidet sich von dem Bauteileverbund 100 gemäß der Fig. 1 dadurch, dass das erste Bauteil 1a auch auf der dem Laserstrahl 10 zugewandten Seite eine Aussparung in Form einer zweiten Aussparung 14 aufweist. Kommt es im Bereich der Verbindungszone 5 zu einer Reflexion der Laserstrahlung, so kann diese in Analogie zum Bauteileverbund 100 das Material der Umspritzung 12 auf der dem Laserstrahl 10 zugewandten Seite durchdringen, ohne dass das Material der Umspritzung 12 beschädigt bzw. aufgeschmolzen wird.

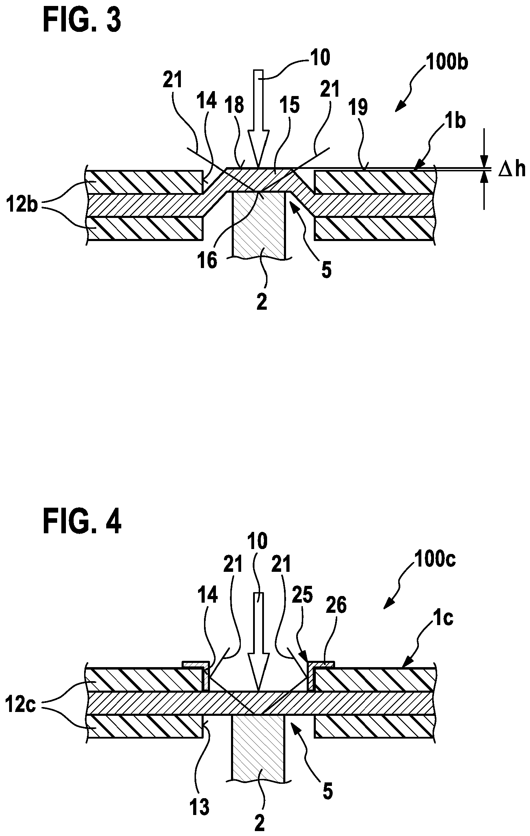

Bei dem Bauteileverbund 100b gemäß der Fig. 3, der nach einem erfindungsgemäßen Verfahren ausgebildet wurde, weist das erste Bauteil 1b eine Erhebung 15 auf, die durch bereichsweises Um- bzw. Verformen des ersten Bauteils 1b im Bereich der Verbindungszone 5 ausgebildet wurde, beispielsweise durch Prägen. Ferner erkennt man, dass die Erhöhung 15 auf der dem zweiten Bauteil 2 zugewandten Seite mit einer ebenen Unterseite 16 ausgebildet ist, um eine flächige Anlage des zweiten Bauteils 2 an dem ersten Bauteil 1b zu ermöglichen. Erfindungswesentlich ist, dass die dem Laserstrahl 10 zugewandte Oberseite 18 des ersten Bauteils 1b in Bezug zu dem Laserstrahl 10 eine derartige Höhe aufweist, dass die Oberseite 18 des ersten Bauteils 1b zumindest bündig mit der Oberseite 19 der Umspritzung 12 auf dem Laserstrahl 10 zugewandten Seite abschließt, vorzugsweise jedoch die Oberseite 19 des ersten Bauteils 1b um einen Betrag Δh in der Höhe überragt. Das erste Bauteil 1b weist auf beiden Seiten im Bereich der Verbindungszone 5 eine Aussparung 13, 14 auf.

Bei dem Bauteileverbund 100b ist es nicht erforderlich, dass das Material der Umspritzung 12b des ersten Bauteils 1b aus einem für den Laserstrahl 10 transparentem Material besteht. Durch die spezifische Ausbildung bzw. Geometrie des ersten Bauteils 1b mit dessen Erhebung 15 ist gewährleistet, dass von der Oberseite 19 des ersten Bauteils 1b reflektierte Streustrahlen 21 des Laserstrahl 10 stets derart reflektiert werden, dass diese nicht in den Bereich der Umspritzung 12b auf der dem Laserstrahl 10 zugewandten Seite gelangen. Ferner weist das erste Bauteil 1b entsprechend dem Bauteileverbund 100a eine erste Aussparung 13 auf der dem zweiten Bauteil 2 zugewandten Seite und eine zweite Aussparung 14 auf der dem Laserstrahl 10 zugewandten Seite auf, wobei die beiden Aussparungen 13, 14 beispielhaft die gleiche Größe aufweisen.

Zuletzt ist in der Fig. 4 ein Bauteileverbund 100c dargestellt, der sich von dem Bauteileverbund 100a gemäß der Fig. 2 dadurch unterscheidet, dass das Material der Umspritzung 12c ebenfalls aus einem für den Laserstrahl 10 nicht transparenten Material besteht. Um zu vermeiden, dass Streustrahlen 21 auf der dem Laserstrahl 10 zugewandten Seite in das Material der Umspritzung 12c eindringen und diese ggf. beschädigen ist es vorgesehen, dass im Bereich der zweiten Aussparung 14 ein beispielhaft hülsenförmig ausgebildetes Schutzelement 25 angeordnet ist, das einen radial umlaufenden Bund 26 aufweist, der auf der Oberseite 18 des ersten Bauteils 1c aufliegt. Ferner ist es vorzugsweise vorgesehen, dass das Schutzelement 25, das als verlorenes Schutzelement 25 ausgebildet ist, mit dem ersten Bauteil 1c verbunden ist, beispielsweise durch eine Verklebung, eine kraftschlüssige Verbindung wie eine Klemmverbindung o.ä. Das Schutzelement 25 besteht beispielsweise aus Metall oder einem sonstigen Werkstoff, der entweder den Laserstrahl 10 reflektiert oder aber diesen absorbiert, ohne dass das Material der Umspritzung 12c beschädigt wird.

Die soweit beschriebenen Verfahren zum Verbinden zweier elektrisch leitender Bauteile 1b, 2 können in vielfältiger Art und Weise abgewandelt bzw. modifiziert werden, ohne vom Schutzbereich der Ansprüche abzuweichen.

## Patentansprüche

1. Verfahren zum Verbinden zweier elektrisch leitender Bauteile (1b, 2) mittels
eines Laserstrahls (10), wobei das der Seite des Laserstrahls (10) zugewandte erste Bauteil (1b) bereichsweise mit einer aus Kunststoff bestehenden Umspritzung (12b) versehen ist und im Bereich einer Verbindungszone (5) der beiden Bauteile (1b, 2) auf beiden Seiten eine von der Umspritzung (12b) freie Aussparung (13, 14) aufweist, und wobei das dem Laserstrahl (10) abgewandte zweite Bauteil (2) im Bereich der Verbindungszone (5) an dem ersten Bauteil (1b) zumindest bereichsweise anliegt,
wobei das erste Bauteil (1b) im Bereich der Verbindungszone (5) auf der dem Laserstrahl (10) zugewandten Seite mit einer Erhöhung (15) ausgebildet ist, so dass das erste Bauteil (1b) zumindest bis in Höhe der Oberseite (19) des Kunststoffes der Umspritzung (12b) auf der dem Laserstrahl (10) zugewandten Seite reicht und vorzugsweise die Umspritzung (12b) um einen Betrag Δh in der Höhe überragt.

2. Verfahren nach Anspruch 1,
**dadurch gekennzeichnet,**
**dass** das erste Bauteil (1b) im Bereich der Aussparung (13, 14) zur Ausbildung der Erhöhung (15) zumindest bereichsweise verformt wird.

3. Bauteileverbund (100b), hergestellt nach einem Verfahren der Ansprüche 1 bis 2, wobei das erste Bauteil (1b) ein aus Kupfer bestehendes Stanzgitter ist.

4. Bauteileverbund nach Anspruch 3,
**dadurch gekennzeichnet,**
**dass** das zweite Bauteil (2) zumindest im Bereich der Verbindungszone (5) stiftförmig ausgebildet ist.

5. Bauteileverbund nach Anspruch 3 oder 4 als Bestandteil eines Steuergeräts in einem Kraftfahrzeug.

## Claims

1. Method for connecting two electrically conductive components (1b, 2) by means of a laser beam (10), wherein the first component (1b), which faces the side of the laser beam (10), is provided in regions with an injection-moulded encapsulation (12b) consisting of plastics material and has a recess (13, 14) free of the injection-moulded encapsulation (12b) on either side in the region of a connection zone (5) of the two components (1b, 2), and wherein the second component (2), which is remote from the laser beam (10), bears at least in certain regions against the first component (1b) in the region of the connection zone (5),
wherein
the first component (1b) is formed with an elevation (15) on the side facing the laser beam (10) in the region of the connection zone (5), with the result that the first component (1b) reaches at least up to the top side (19) of the plastics material of the injection-moulded encapsulation (12b) on the side facing the laser beam (10) and preferably protrudes in height beyond the injection-moulded encapsulation (12b) by a magnitude Δh.

2. Method according to Claim 1,
**characterized in that**
the first component (1b) is deformed at least in certain regions in the region of the cutout (13, 14) in order to form the elevation (15).

3. Component composite (100b), produced by a method of Claims 1 and 2, wherein the first component (1b) is a leadframe consisting of copper.

4. Component composite according to Claim 3, **characterized in that**
the second component (2) has a pin-shaped form at least in the region of the connection zone (5).

5. Component composite according to Claim 3 or 4 as constituent part of a control unit in a motor vehicle.

## Revendications

1. Procédé de raccordement de deux composants conducteurs d'électricité (1b, 2) au moyen d'un faisceau laser (10), le premier composant (1b) tourné vers le côté du faisceau laser (10) étant muni par endroits d'un surmoulage (12b) en matière plastique et présentant au niveau d'une zone de raccordement (5) des deux composants (1b, 2) des deux côtés un évidement (13, 14) exempt du surmoulage (12b), et le deuxième composant (2) détourné du faisceau laser (10) étant adjacent au moins par endroits au premier composant (1b) au niveau de la zone de raccordement (5),
le premier composant (1b) étant réalisé avec un relief (15) au niveau de la zone de raccordement (5) du côté tourné vers le faisceau laser (10) de sorte que le premier composant (1b) atteint au moins la hauteur de la face supérieure (19) de la matière plastique du surmoulage (12b) sur le côté tourné vers le faisceau laser (10) et dépasse de préférence le surmoulage (12b) d'une quantité Δh en hauteur.

2. Procédé selon la revendication 1, **caractérisé en ce que** le premier composant (1b) se déforme au moins par endroits au niveau de l'évidement (13, 14) pour réaliser le relief (15).

3. Ensemble de composants (100b), fabriqué selon un procédé des revendications 1 à 2, dans lequel le premier composant (1b) est un grillage estampé composé de cuivre.

4. Ensemble de composants selon la revendication 3, **caractérisé en ce que** le deuxième composant (2) est réalisé en forme de tige au moins au niveau de la zone de raccordement (5).

5. Ensemble de composants selon la revendication 3 ou 4 sous forme de composant d'un appareil de commande dans un véhicule automobile.
